# EUROPEAN PATENT SPECIFICATION

(11) **EP 4 143 874 B1**
(45) Date of publication and mention of the grant of the patent: **19.11.2025**
(21) Application number: 21796680.3
(22) Date of filing: 23.04.2021
(51) Int. Cl.: B81B 7/00

(54) **MEMS HERMETIC SEAL APPARATUS AND METHODS**
HERMETISCHE MEMS-DICHTUNGSVORRICHTUNG UND VERFAHREN
APPAREIL ET PROCÉDÉS DE SCELLEMENT HERMÉTIQUE DE MEMS

(30) Priority: 29.04.2020 US 202063017316 P
(43) Date of publication of application: 08.03.2023
(73) Proprietor: Elbit Systems of America, LLC, Fort Worth, TX 76179 (US)
(72) Inventor: CHILCOTT, Dan W., Fort Worth, Texas 76179 (US); SMITH, Arlynn W., Fort Worth, Texas 76179 (US)
(74) Representative: Jaeger, Michael David
(86) International application number: PCT/US2021/028845
(87) International publication number: WO 2021/222020

(56) References cited:
- WO-A1-2015/061212
- US-A- 5 837 935
- US-A1- 2019 198 409
- US-B2- 10 584 027
- US-B2- 8 546 928

## Description

### PRIORITY CLAIM

The present application is a continuation of pending Patent Application Serial No. 63/017,316, filed April 29, 2020, from which priority is claimed.

### BACKGROUND

Microelectromechanical system (MEMS) devices include micromechatronics and/or microsystems that are implemented into microscopic devices. Microelectromechanical (alternatively referred to as MEMS) devices, can be made up of components between 0.1 and 100 microns in size, and the MEMS devices generally range in size from 0.02 to 25 millimeters. MEMS devices can include a central unit that processes data (an integrated circuit chip such as a microprocessor) and several microelectronic and/or micromechanical components that interact with the surroundings.

MEMS devices are advantageously produced using semiconductor fabrication techniques. For example, MEMS device can be formed in a cavity that exists when stacking two or more die within respective semiconductor wafers. One die can be provided on a carrier, for example, and another die can be mounted on top of the first die. Stacked die and wafer arrangements, including hermetic sealing and bonding arrangements, may be used to form a MEMS package, or assembly, containing micromechanical and microelectronic components such as sensors and their supporting circuitry. It is desirable that the stacked die and wafers be sealed at their joined perimeter surfaces to form a vacuum cavity into which the MEMS device is arranged. In some instances, making the hermetic seals reliable and long-lasting can be problematic, particularly at the die or chip scale.

Document WO 2015/061212 A1 shows a device as defined in the preamble of claim 1.

### SUMMARY

The present invention is defined in claim 1, and relates to hermetic sealing of devices, and to device-packaged assemblies. The sealable device is preferably a sealable microelectromechanical (MEMS) device, and the assembly is a microelectromechanical (MEMS) assembly. The sealable device can be positioned on (or formed on or within) a substrate. A first seal member can also be positioned on the substrate. The first seal member defines an internal cavity. The microelectromechanical device is positioned within the internal cavity. A second seal member is positioned outside of the first seal member. A seal region is defined between the first seal member and the second seal member. Getter material is positioned within the seal region.

According to at least one example of the disclosure, a hermetically sealed microelectromechanical assembly is provided. The microelectromechanical assembly can include a first substrate. A first seal member can be patterned on the first substrate completely surrounding a cavity in which a microelectromechanical device is arranged. The microelectromechanical device is arranged a spaced distance from the first seal member, and specifically arranged a spaced distance from an inside, sidewall or lateral surface of the first seal member. A second seal member can be patterned on the first substrate surrounding the first seal member a spaced distance from the first seal member. A first seal region is defined by the extents of the cavity. A second seal region is defined between the first seal member and the second seal member, and specifically between lateral surfaces of the first and second seal members that face each other. A first getter material can be positioned in the first seal region and a second getter material can be positioned in the second seal region. The first getter material can be the same, as or different from, the second getter material.

According to at least a further example of the disclosure, a third seal member can be patterned on the first substrate, completely surrounding the second seal member and at a spaced distance from the second seal member. A third seal region is defined between the third seal member and the second seal member. A third getter material can be positioned within the third seal region. When activated, either upon evacuation or both evacuation and heating, the first getter material completes and/or maintains the vacuum in the first seal region and also reacts with gases in the first seal region to remove gases from the first seal region. The second and third getter material can perform the same functions by maintaining vacuum and gas removal in the respective second and third seal regions. The third getter material can be the same as, or different from, the second getter material.

According to yet at least another further example of the disclosure, a method is provided for forming a microelectromechanical assembly or package. The method includes forming the microelectromechanical device on the first substrate. Semiconductor fabrication, including deposition, etch and general photolithography processes, can form the microelectromechanical device as part of the first substrate, possibly fabricated on a wafer die area that is the substrate. The substrate can therefore be a semiconductor substrate. Alternatively, the microelectromechanical device can be formed on a semiconductor substrate as a die that is thereafter electrically coupled, or bonded, to the first substrate. Whether the microelectromechanical device is formed within or on the first substrate, the first substrate is preferably a semiconductor wafer of controlled, minimal variation in surface planarity. The first seal member is preferably patterned at the same time as the second seal member, where both are patterned using photoresist and etching techniques applied to a seal material that can extend across the entire first substrate topology. After patterning, the first seal member appears as a circular, rectangular, trapezoidal, quadrilateral, etc. ring that completely surrounds the microelectromechanical device at a first spaced distance from the microelectromechanical device. The ring can be any shape, include partial straight or arcuate walls, provided the first seal member surrounds the microelectromechanical device. The second seal member also appears of similar shape to that of the first seal member, or different from the first seal member, as long as the second seal member completely surrounds the first seal member a second spaced distance from the first seal member. The first spaced distance can vary along the space between the microelectromechanical device and the first seal member. Likewise, the second spaced distance can vary along the space between the first seal member and the second seal member. The first spaced distance can be the same, or different from, the second spaced distance.

First getter material can be applied on the second substrate. Before or after applying the first getter material on the second substrate, second getter material is applied on the first substrate between the first and second seal members. The first getter material is then aligned a spaced distance over the microelectromechanical device as the second substrate is sealed to the first substrate at the first and second seal members. The first and second seal regions can therefore be sealed to a substrate to create and maintain a vacuum in the first and second seal regions. The getter material is applied at select areas to maintain the vacuum, and to react with and remove gases from seal regions.

Additional features and advantages of the disclosed apparatus and method are described in, and will be apparent from, the following description and figures.

### BRIEF DESCRIPTION OF THE FIGURES

FIG. 1 is a perspective view of a hermetically sealed microelectromechanical, or MEMS, device with a single seal, according to a prior art hermetically sealed MEMS device system;
FIG. 2 is a view of a hermetically sealed MEMS device with a pair of seals, according to an embodiment of the invention;
FIGs. 3A and 3B is a pair of views of the hermetically sealed MEMS device of FIG. 2, including a side cross sectional plan view of the hermetically sealed MEMS device in a first state;
FIGs. 4A and 4B is a pair of views of the hermetically sealed MEMS device of FIG. 2, including a side cross sectional plan view of the hermetically sealed MEMS device in a second, vacuum state; and
FIG. 5 is a sequence of method operations, steps or acts for forming a microelectromechanical assembly containing a hermetically sealed MEMS device.

### DETAILED DESCRIPTION OF EXAMPLE EMBODIMENTS

Microelectromechanical or MEMS devices employ semiconductor fabrication techniques to create the small mechanical structures on a surface of a substrate, such as a semiconductor wafer. In the production of MEMS devices, semiconductor fabrication techniques are used to create the moving structures that sense temperature, displacement, acceleration, electronic particles, etc.

The packaging of such MEMS devices poses many challenges. A MEMS assembly, or package, can comprise stacked dies and wafer that are sealed at their joined perimeter surfaces. The stacked and sealed dies of corresponding semiconductor wafers can form a cavity inside the perimeter in which a device, which can be a MEMS device, is arranged within the cavity. The device is formed as part of a die that can be electrically coupled or bonded to a substrate of another die or wafer, or to a chip carrier. The device can therefore be included with a semiconductor substrate, or bonded to another semiconductor substrate of another wafer. In either example, the device of the resulting assembly is preferably arranged in a cavity that is hermetically sealed from exposure to the ambient, outside environment.

Reliable and long-lasting hermetic sealing is necessary in the performance of many devices including sensors, detectors and the like. MEMS hermetic sealing methods and systems often use a single sealing ring to seal a vacuum within an internal cavity region where a microelectromechanical device resides. The single sealing ring may be constructed of a metal, glass frit, solders, or other direct bonding materials. The internal cavity region may include a getter material to maintain the target vacuum level. As noted herein, a getter material is a reactive material or similar material that is placed inside a vacuum system for the purpose of completing and maintaining the vacuum. When gas molecules strike the getter material, they combine with it chemically or by absorption, causing removal of gas from the evacuated space. Getter material can be applied as a coating to a surface within the evacuated chamber. When activated through the evacuation process, and/or when combined with thermal energy, the getter material can then remove gases to maintain the vacuum within the chamber.

A MEMS device is hermetically sealed inside a chamber or cavity using preferably at least two seal members with getter deposited in both the cavity and between the seal members. The present disclosure provides for positioning at least two seal members around a MEMS device contained in an internal cavity. The seal members form a vacuum seal and decrease the leak rate of the hermetic seal of the overall MEMS assembly. Getter - or a similar reactive material that is placed inside a vacuum system for the purpose of improving the efficiency of that vacuum by scavenging unwanted contaminate - is positioned between the seal members and disposed within the internal cavity to facilitate vacuum. The removal or maintenance of the vacuum is described herein as "getter pump/pumping." The getter material within the vacuum continually removes residual gas as it is produced, often achieving a higher vacuum than the pump could achieve alone. Accordingly, a getter is itself a vacuum pump. The positioning of getter between the pair of seal members forms a double pumped structure (e.g., two regions of getter pumping): a first being in a first seal region defined in the cavity where the MEMS device resides, and a second being in a second seal region defined between the first seal member and the second seal member. Using a double pumped assembly structure provides a lower leak rate, and maintains the lower leak rate longer, as compared to previous hermetically sealed MEMS assemblies. If the leak is from one of the seal surfaces or rings, the getter intercepts the leak before the gas reaches the main device cavity. If the inner seal ring has a higher leak rate than the interstitial getter, this can also help pump the device cavity. However, the leak rate itself is unchanged as is the seal ring with the slowest rate. The interstitial getter also helps remove any physical or chemical absorb species in the interstitial space which may not have been removed or cleaned off during the initial processing which, but for the getter, might leak into the main cavity as well. As noted further below, in some example embodiments, a triple pumped assembly can be utilized to further lower the leak rate.

In various embodiments, a plurality of seal members are positioned substantially concentric with one another (e.g., redundant seal lines) and getter pumping occurs therebetween. The seal members are preferably printed lines on a substrate. Getter pumping occurs between spaced seal lines of adjacent yet spaced seal members to hermetically seal one or more MEMS devices positioned in an internal cavity. The implementation of redundant seal lines provides a larger "effective" getter area. Any leak from the outer environment through the outer seal line (e.g., the outermost seal member) is pumped by the getter deposited between those seal lines. A maximum leak rate of the interior cavity is determined by a seal line in the plurality of seal lines having the lowest leak rate. The addition of more seal members, and getter material positioned between the seal lines of the additional seal members, increases the probability of several low leak rate lines. However, the probability of at least one seal member with a very low leak rate increases as the number of seal members increase, thereby lowering the leak rate of the overall device packaged assembly.

The integrity of a sealed cavity can be looked at as a function of the volume of the cavity. By placing several concentric seal members spaced from each other, and each completely around the cavity and the inner seal member, the leak rate for an internal cavity of approximately 0.01cc can be reduced to less than 1e-13 to 1e-15 Torr*1/sec.

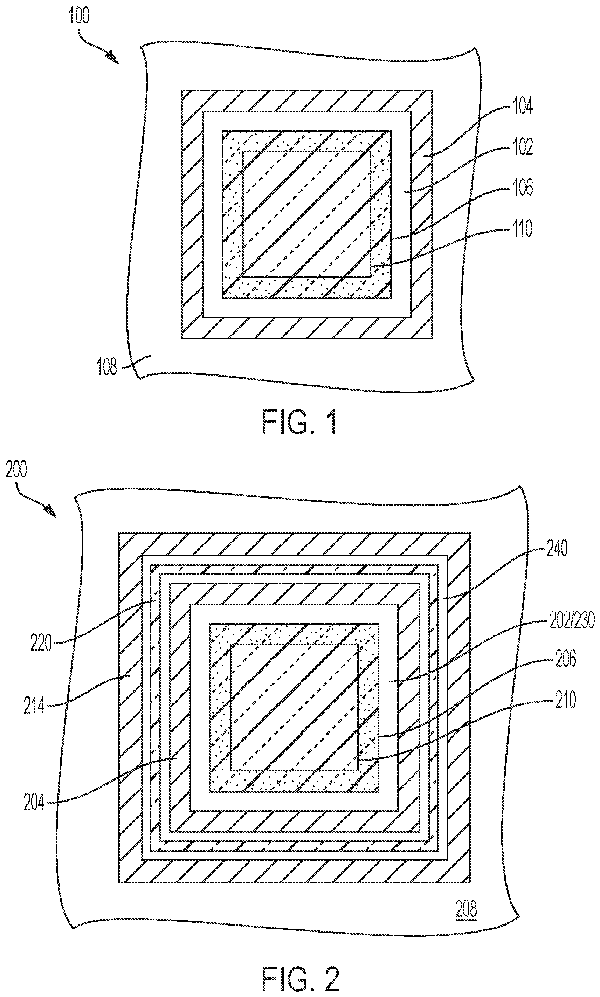

FIG. 1 illustrates a hermetically sealed device assembly or package 100. Assembly 100 can include any semiconductor device, an example of such is a MEMS device 106. MEMS device can be formed as part of a wafer or die and/or configured on a wafer as a die. The MEMS device package 100 is hermetically sealed with MEMS device 106 arranged within a cavity 102. Cavity 102, and MEMS device 106, is surrounded by a seal ring 104. Seal ring 104 hermetically seals an overlying substrate to underlying substrate 108. As noted above, MEMS device 106 can include a sensor or detector for sensing force, temperature, electronic particles (e.g., electrons), etc. Seal ring 104 can be formed on a substrate 108 of a wafer containing an array of die, one of which can contain MEMS device 106, or possibly a die below MEMS device 106 onto which MEMS device 106 is electrically coupled. MEMS device 106 can include micro mechanical moving elements that are preferably sealed in a vacuum cavity 102 by seal member 104 extending between the underlying substrate 108 and an overlying substrate to maintain MEMS operation.

According to one embodiment, the seal member 104 can comprise metal, or multiple layers of metal, formed on substrate 108. Seal member 104 can be formed by patterning a seal layer of one or more layers of metal on the topology of substrate 108. The resulting patterned seal member 104 has a photolithography-defined width that defines the outer extent of cavity 102 and is a spaced distance from MEMS device 106. The seal member 104 can be deposited using various semiconductor fabrication techniques, or through electroless plating, electro-deposition, or various combination thereof. The seal ring 104 can be made of one or more layers of metallic material such as copper, gold, lead, tin, aluminum, platinum or other suitable material or combination of materials that can provide a good wetting surface for solder. According to another embodiment, the seal ring 104 may be made of non-metallic material, such as glass frit, ceramics or other combination of non-metallic substances. The seal mechanism is performed by compression, thermocompression, or by other techniques that seal, against ingress/egress, seal member 104 between upper and lower substrates.

Getter material 110 is positioned within the internal cavity 102. The cavity 102 incorporates getter material 110 to maintain a target vacuum level. However, using a single seal member 104 for hermetically sealing a MEMS device suffer from a high leak rate and implement only a single vacuum pumped structure. Further, in the current systems and methods for hermetically sealed MEMS devices, alterations of the material of the seal ring and/or the material of the getter typically result in a measurable-and undesirable-leak rate in the fabricated devices.

Turning to FIG. 2, a top view illustrates a MEMS device 206 hermetically sealed in a MEMS assembly 200. MEMS assembly, or package, 200 is shown having a first seal member 204 and a second seal member 214 according to an example embodiment. A first getter material 210 is positioned within cavity 202, also known as first seal region 230. A second getter material 220 is positioned between the first seal member 204 and the second seal member 214. The space between the first seal member 204 and the second seal member 214 is shown as the second seal region 240. The positioning of a second seal member 214 around the first seal member 204, and using a second getter material 220 in the second seal region 240 between the second seal member 214 and the first seal member 204 decreases the leak rate of the hermetically sealed MEMS assembly 200 as a whole.

Beneficially, the second seal member 214-and embodiments with additional seal members (e.g., three, four, five, etc.)-provides a lower leak rate of the hermetically sealed MEMS assembly 200 compared to the single seal member hermetically sealed MEMS assembly 100. The second seal member 214 of the hermetically sealed MEMS device 200 provides a redundant seal line and dual/multiple getter/vacuum pumping between the first and second seal members 204, 214. Accordingly, a leak in the outer seal member (e.g., second seal member 214) from the atmosphere through the outer seal member is pumped by the getter material 220 deposited between the seal lines increasing the "effective" getter area of the hermetically sealed MEMS assembly 200. Conversely, a leak in the outer seal member of the existing hermetically sealed MEMS devices, as shown in FIG. 1, exposes the ambient, outside atmosphere to the internal cavity and the MEMS device 106 positioned therewithin.

Referring to FIG. 2, the first seal member 204 is positioned completely around and seals the MEMS device 206 in an internal cavity 202, where the internal cavity 202 defines a first seal region 230. The first seal member 204 can be photolithography printed or additively plated on a first substrate 208. The internal cavity 202, and thus the first seal region 230 incorporates a first getter material 210. The first getter material 210 (as well as the second getter material 220, or additional surrounding getter materials between additional seal members) is deposited using printing, plating, sputtering, resistive evaporation, ebeam evaporation, and comprises reactive materials described above. Examples of suitable getter materials include zirconium, titanium, boron, cobalt, calcium, strontium, thorium, aluminum, barium, magnesium or combination thereof, or alloy combination including hafnium, tantalum, vanadium, niobium, iron and certain rare earth elements. The getter materials, when placed in the appropriate seal regions and activated, maintains the target vacuum level. A second seal member 214 is positioned co-planar to the first seal member 204 upon substrate 208. The second seal member 214 is spaced from the first seal member 204 and further outside of and completely surrounding the internal cavity 202 and the first seal member 204.

The gap between the first seal member 204 and the second seal member 214 defines the second seal region 240. The second getter material 220 is positioned between the first seal member 204 and the second seal member 214 in the second seal region 240. The presence of the second getter material 220 in the second seal region 240 provides a getter pump, such that the hermetically sealed assembly 200 achieves a double pumped structure. The positioning of a second seal member 214 allows getter pumping in successive spaces between seal lines (e.g., between the first seal member 204 and the second seal member 214) resulting in a more effective getter, and a more stable vacuum level. In some embodiments, the second seal region 240 is pumped with a pump or similar device during seal to create a vacuum that is maintained by the getter material 220.

In various embodiments, additional seal members may be positioned outside of and completely surrounding the second seal member 214, with each spaced, successive region between the seal members having getter material to provide a multiple seal member assembly with a plurality of getter pumping regions. For example, a five-seal member hermetically sealed MEMS device would be a five pumped structure that includes (4) four regions of getter material between adjacent seal members and (1) getter material in the internal cavity that is vacuumed sealed. The four regions of getter material provide a greater effective getter pumping area compared to the single seal member/ring implementation.

Since the maximum leak rate to the interior cavity 202 (or first seal region 230) is given by the seal member/ring with the lowest leak rate among multiple seal members. Increasing the number of seal members thereby increases the MEMS sealing probability even if there are several low leak rate seal members. In other words, the implementation of multiple seal member in the hermetically sealed MEMS assembly results in a higher probability of a lower leak rate seal, and a more stable vacuum level, for the MEMS device arranged in the interior cavity 202, or first seal region 230. In some embodiments, the regions of getter material may be vacuum pumped prior to or after the getter material is added to provide multiple members/rings of sealing and vacuum pumping.

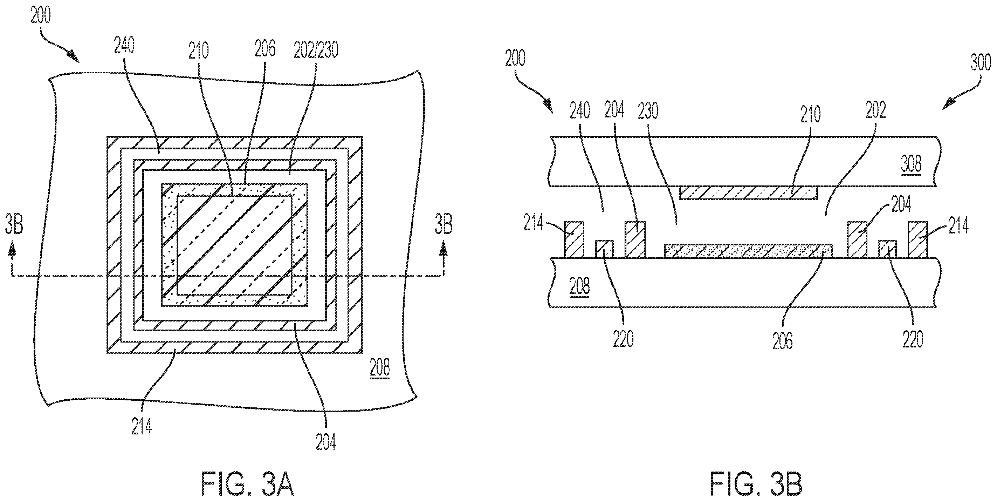

Turning to FIGs. 3A and 3B, a pair of views of the hermetically sealed MEMS device 206 is illustrated. The side cross sectional view (FIG. 3B) of the hermetically sealed MEMS device 206 of FIG. 2 is shown in an unassembled state 300 (e.g., a first state). FIG. 3B is shown taken along plane 3B-3B of FIG. 3A. FIG. 3A is similar to FIG. 2, with second getter 220 removed for drawing clarity. It is understood, however, that second getter 220 nonetheless exist, and is provided in FIG. 3B for completeness. In the unassembled state 300, a second substrate 308 shown in FIG. 3B includes the first getter material 210 positioned thereon. The first substrate 208 has the first seal member 204 positioned thereon and interior of the second seal member 214 with a second seal region 240 positioned between the first and second seal members 204, 214.

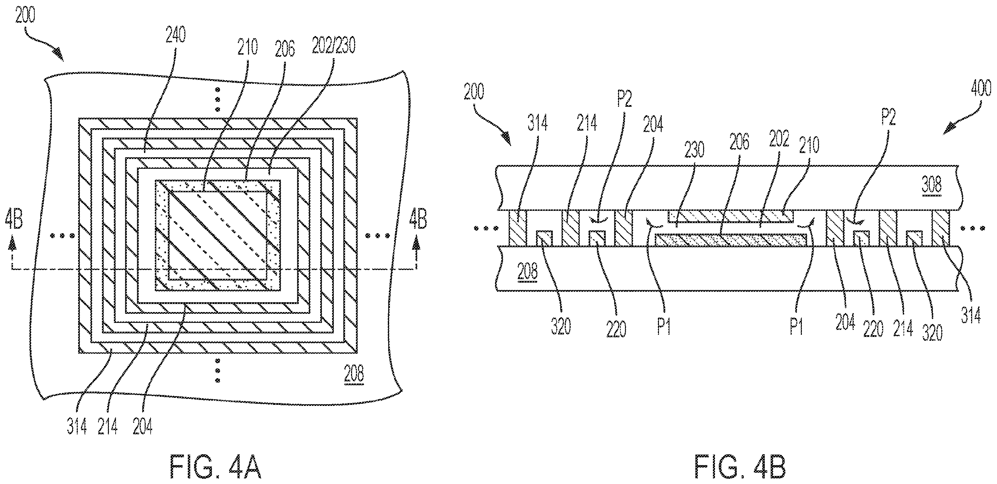

The second substrate 308 is positioned adjacent to and parallel to the first substrate. Getter material can be on either substrates 208 or 308, or on both substrates 208, 308. For example, the first getter material 210 is aligned a spaced distance from MEMS device 206, and the first and second seal members 204, 214, already hermetically sealed on first substrate 208 when applied during patterning or plating on first substrate 208, is sealed at their upper surfaces with a lower surface of second substrate 308. The upper surfaces of first and second seal members 204, 214 are advantageously at the same elevation and are even with each other due to the seal member layer, that is patterned or plated, being of the same thickness and same height due to the similar deposition thickness across a substantially smooth and even topology of the semiconductor wafer used to form substrate 208. The second getter material 220 is also deposited on the first substrate 208 and between opposing lateral surfaces of first and second seal members 204, 214. The lateral surfaces of first and second seal members are substantially directed perpendicular to the upper surface of first substrate 208 by using preferably an anisotropic etch applied to areas of the seal member layer not covered by photoresist, for example. The height of the seal members 204, 214 are therefore the same, and must be greater than the thickness of the MEMS device 206 and first getter material 210, in order to maintain a gap therebetween, as shown in FIG. 4B in the assembled state 400.

Referring to FIG. 4B, the assembled state 400 is shown as a plan cross-section along 4B-4B of FIG. 4A. As before, FIG. 4A does not illustrate the second getter material 220 for sake of clarity in the drawing. However, FIG. 4B does illustrate second getter material 220. FIGs. 4A and 4B illustrate a third seal member 314 completely surrounding and spaced outside of first and second seal members 204, 214. Third seal member 314 is co-planar to the first and second seal members 204, 214, and has an upper surface also coplanar to the upper surfaces of seal members 204, 214. In addition to a third seal member 314, FIGs. 4A and 4B illustrate possibly additional seal members surrounding and spaced outside of the third seal member 314. Those additional seal members would be coplanar to the other seal members and be preferably the same width (measured parallel to the upper surface of first substrate 208) as the other seal members.

Placed between the second seal member 214 and the third seal member is a third getter material 320 (shown in FIG. 4B). Third getter material 320 can be substantially the same thickness as second getter material 220, and possibly the same thickness as the first getter material 210. A vacuum is formed in the first seal region 230, defined by cavity 202, such that the first seal region 230 has a first pressure (P1). The second seal region 240 includes the second getter material 220 and has a second seal pressure (P2). In various embodiments, the first pressure (P1) is greater than the second pressure (P2). In other words, the pressure in the first seal region 230 is greater than the pressure in the second seal region 240. Once sealed, the vacuum level is maintained and the getter materials chemically react with, absorb, and/or adsorb gasses that may degrade the MEMS device 206 that reside in the internal cavity 202 of the sealed assembly 200.

Removing more pressure from the second seal region 240 (resulting in second seal pressure (P2)) then from first seal region 230 (resulting in first seal pressure (P1)) helps ensure greater negative pressure differential away from the MEMS device 206 should the first seal member 204 undergo a leak and the second seal member 214 undergo a smaller leak than the first seal member 204. The getter material 210, 220 placed in the respective first and second seal regions 230, 240 helps maintain the pressure differential. An amount of the first getter material 210 can be more or less than the amount of the second getter material 220, depending on the extent of a desired getter pumping differential. For example, if a greater vacuum is needed in the second seal region to lower P2 relative to the first seal region having pressure P1, then more getter material may be applied in the second seal region 240 relative to the first seal region 230.

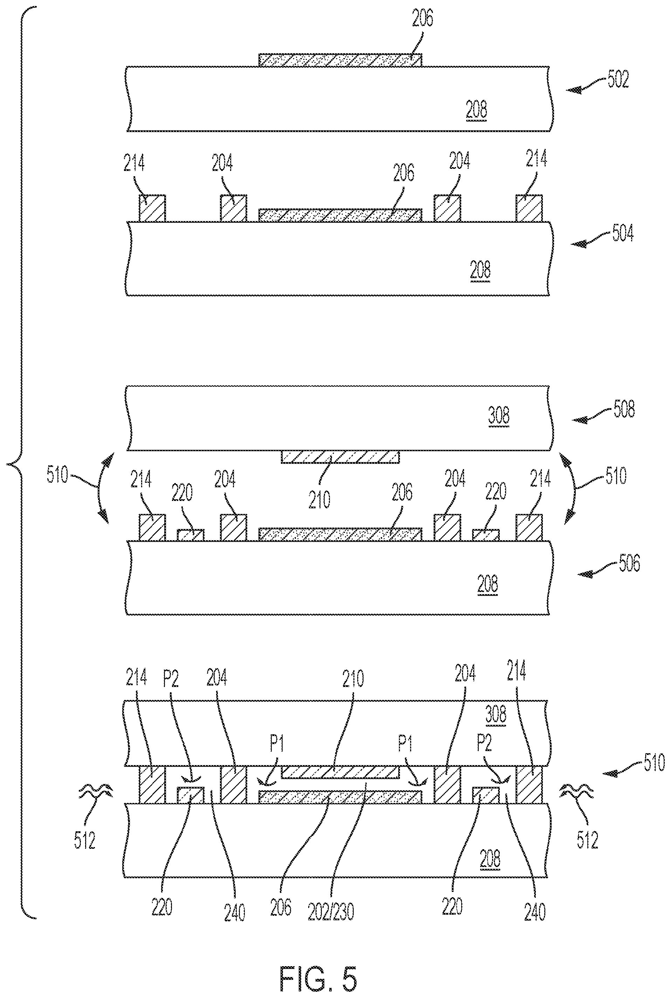

Referring to FIG. 5, a method of forming a MEMS assembly is shown. One step 502 of the method includes forming a MEMS device on or within a substrate. The substrate containing the MEMS device can be substrate 208, or a substrate upon substrate 208. If the MEMS device 206 is formed on or within a substrate, then the as-formed substrate containing MEMS device 206 can be applied to substrate 208, as shown. The MEMS device 206 can be produced as a die from a semiconductor wafer.

In step 504, first and second seal members 204, 214 are formed simultaneously with one another. Whether the seal members 204, 214 are a single layer or multiple layers, each layer is deposited across the topology of substrate 208 in succession. Thereafter, the single or multiple layer seal material deposited across the topology are selectively removed using photoresist and etching, leaving behind the first and second seal members 204, 214.

In step 506, a second getter material 220 can be placed on substrate 208 between first and second seal members 204, 214. The second getter material can also be placed on lateral surfaces of the seal members 204, 214 that face each other. Before or after applying the second getter material 220 at step 506, a first getter material 210 can be applied to the second substrate 308 at step 508. Thus, the order can be reversed as shown by arrows 510. Preferably, first getter material is applied to a surface of substrate 308 that is parallel to and faces a surface of substrate 208 on which MEMS device 206 is formed.

While aligning the first getter material 210 a spaced distance over MEMS device 206, at step 510 a cavity 202 is formed in the gap or space between first getter material 210 and device 206. The cavity is formed in a vacuum by sealing the second substrate 308 to the first substrate 208. The hermetic seal occurs at the boundary between the upper surfaces of the first and second seal members 204, 214 and the lower surface of the second substrate 308. Vacuum pressures P1 and P2 are created when the first and second seal regions 230, 240 are formed, by evacuating at the boundary during sealing. The first and second getter materials 210, 220 are activated either during the vacuum sealing or afterwards when applying thermal energy 512.

It is important to note that the construction and arrangement of the various example embodiments are illustrative only. Although only a few embodiments have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter described herein. For example, elements shown as integrally formed may be constructed of multiple parts or elements, the position of elements may be reversed or otherwise varied, and the nature or number of discrete elements or positions may be altered or varied. The order or sequence of any process or method steps may be varied or re-sequenced according to alternative embodiments. Additionally, features from particular embodiments may be combined with features from other embodiments as would be understood by one of ordinary skill in the art. Other substitutions, modifications, changes and omissions may also be made in the design, operating conditions and arrangement of the various example embodiments without departing from the scope of the present invention.

As used herein and in the appended claims, the singular form of a word includes the plural, unless the context clearly dictates otherwise. Thus, the references "a," "an" and "the" are generally inclusive of the plurals of the respective terms. For example, reference to "a feature" includes a plurality of such "features." The term "and/or" used in the context of "X and/or Y" should be interpreted as "X," or "Y," or "X and Y.

It should be noted that any use of the term "example" herein to describe various embodiments is intended to indicate that such embodiments are possible examples, representations, and/or illustrations of possible embodiments (and such term is not intended to connote that such embodiments are necessarily extraordinary or superlative examples). Further, as utilized herein, the term "substantially" and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed (e.g., within plus or minus five percent of a given angle or other value) are considered to be within the scope of the invention as recited in the appended claims. The term "approximately" when used with respect to values means plus or minus five percent of the associated value.

The terms "coupled" and the like as used herein mean the joining of two members directly or indirectly to one another. Such joining may be stationary (e.g., permanent) or moveable (e.g., removable or releasable). Such joining may be achieved with the two members or the two members and any additional intermediate members being integrally formed as a single unitary body with one another or with the two members or the two members and any additional intermediate members being attached to one another.

It should be noted that although the diagrams herein may show a specific order and composition of method steps, it is understood that the order of these steps may differ from what is depicted. For example, two or more steps may be performed concurrently or with partial concurrence. Also, some method steps that are performed as discrete steps may be combined, steps being performed as a combined step may be separated into discrete steps, the sequence of certain processes may be reversed or otherwise varied, and the nature or number of discrete processes may be altered or varied. The order or sequence of any element or apparatus may be varied or substituted according to alternative embodiments. Accordingly, all such modifications are intended to be included within the scope of the present invention as defined in the appended claims.

Without further elaboration, it is believed that one skilled in the art can use the preceding description to utilize the claimed inventions to their fullest extent. The examples and embodiments disclosed herein are to be construed as merely illustrative and not a limitation of the scope of the present disclosure in any way. It will be apparent to those having skill in the art that changes may be made to the details of the above-described embodiments without departing from the underlying principles discussed. In other words, various modifications and improvements of the embodiments specifically disclosed in the description above are within the scope of the appended claims. For example, any suitable combination of features of the various embodiments described is contemplated.

## Claims

1. A sealable device (200) comprising:
a first substrate (208);
a first seal member (204) positioned on the first substrate (208), the first seal member (204) defining an internal cavity (202);
a microelectromechanical device (206) positioned within the internal cavity (202);
a second seal member (214) positioned outside of the first seal member (204);
a seal region (240) defined between the first seal member (204) and the second seal member (214); and **characterized in that**
getter material (220) is positioned within the seal region (240), the getter material being configured to remove gases from the seal region.

2. The sealable device of claim 1, wherein the getter material is a second getter material, further comprising a second substrate wherein a first getter material is positioned on the second substrate, the first getter material configured to remove gases from the internal cavity.

3. The sealable device of claim 2, wherein the second substrate seals with the first seal member and the second seal member to form a vacuum in the internal cavity.

4. The sealable device of claim 1, wherein the getter material is a second getter material and wherein the seal region is a second seal region, further comprising a third seal member positioned outside of the second seal member; a third seal region defined between the third seal member and the second seal member; and third getter material positioned within the third seal region, the second getter material configured to remove gases from the seal region.

5. The sealable device of claim 4, further comprising a second substrate wherein a first getter material is positioned on the second substrate, the first getter material configured to remove gases from the internal cavity.

6. The sealable device of claim 5, wherein the second substrate seals with the first seal member, the second seal member, and the third seal member to form a vacuum in the internal cavity.

7. The sealable device of claim 1, further comprising a microelectromechanical assembly, wherein the microelectromechanical assembly comprises:
the first substrate;
the first seal member (204), wherein the first seal member (204) is patterned on the first substrate completely surrounding the internal cavity (202) in which the microelectromechanical device (206) is arranged a spaced distance from the first seal member (204);
the second seal member (214), wherein the second seal member (214) is patterned on the first substrate (208) completely surrounding the first seal member (204) a spaced distance from the first seal member (204);
a first seal region (230) defined in the cavity (202);
a second seal region (240) defined between the first seal member (204) and the second seal member (214);
a first getter material (210) positioned in the first seal region (230); and
a second getter material (220) positioned in the second seal region (240).

8. The sealable device of claim 7, wherein the first and second getter material comprises a material deposited in the first and second seal regions, respectively, and, upon evacuation and heating of the first and second seal regions, the first and second getter materials are configured to remove gases from the first and second seal regions.

9. The sealable device of claim 8, wherein evacuation of the second seal region is greater than evacuation of the first seal region to create greater pressure in the first seal region than the second seal region.

10. The sealable device of claim 9, wherein the pressure in the first and second seal regions is less than one atmosphere, and more preferably less than 0.5 atmosphere.

11. The sealable device of claim 7, wherein the first and second seal members are patterned on the first substrate by depositing a seal material on the first substrate and selectively removing the deposited seal material leaving the first and second seal members substantially coplanar to each other on the first substrate.

12. The sealable device of claim 7, wherein the microelectromechanical assembly further comprises a second substrate spaced parallel to the first substrate and having the first and second seal members hermetically sealed therebetween.

13. The sealable device of claim 12, wherein the first substrate and the second substrate comprise semiconductor substrates.

14. The sealable device of claim 12, wherein the first getter material is deposited on a surface of the second substrate that faces the first substrate.

15. The sealable device of claim 13, wherein the second getter material is deposited on a surface of the first substrate that faces the second substrate.

## Patentansprüche

1. Abdichtbare Vorrichtung (200), die Folgendes umfasst:
ein erstes Substrat (208);
ein erstes Dichtungselement (204), das auf dem ersten Substrat (208) positioniert ist, wobei das erste Dichtungselement (204) einen inneren Hohlraum (202) definiert;
eine mikroelektromechanische Vorrichtung (206), die innerhalb des inneren Hohlraums (202) positioniert ist;
ein zweites Dichtungselement (214), das außerhalb des ersten Dichtungselements (204) positioniert ist;
eine Dichtungsregion (240), die zwischen dem ersten Dichtungselement (204) und dem zweiten Dichtungselement (214) definiert ist; und
**dadurch gekennzeichnet, dass** Gettermaterial (220) innerhalb der Dichtungsregion (240) positioniert ist, wobei das Gettermaterial zum Entfernen von Gasen aus der Dichtungsregion konfiguriert ist.

2. Abdichtbare Vorrichtung nach Anspruch 1, wobei das Gettermaterial ein zweites Gettermaterial ist, das ferner ein zweites Substrat umfasst, wobei ein erstes Gettermaterial auf dem zweiten Substrat positioniert ist, wobei das erste Gettermaterial zum Entfernen von Gasen aus dem inneren Hohlraum konfiguriert ist.

3. Abdichtbare Vorrichtung nach Anspruch 2, wobei das zweite Substrat mit dem ersten Dichtungselement und dem zweiten Dichtungselement abdichtet, um ein Vakuum im inneren Hohlraum zu bilden.

4. Abdichtbare Vorrichtung nach Anspruch 1, wobei das Gettermaterial ein zweites Gettermaterial ist und wobei die Dichtungsregion eine zweite Dichtungsregion ist, ferner umfassend ein außerhalb des zweiten Dichtungselements positioniertes drittes Dichtungselement; eine zwischen dem dritten Dichtungselement und dem zweiten Dichtungselement definierte dritte Dichtungsregion; und innerhalb der dritten Dichtungsregion positioniertes drittes Gettermaterial, wobei das zweite Gettermaterial zum Entfernen von Gasen aus der Dichtungsregion konfiguriert ist.

5. Abdichtbare Vorrichtung nach Anspruch 4, die ferner ein zweites Substrat umfasst, wobei ein erstes Gettermaterial auf dem zweiten Substrat positioniert ist, wobei das erste Gettermaterial zum Entfernen von Gasen aus dem inneren Hohlraum konfiguriert ist.

6. Abdichtbare Vorrichtung nach Anspruch 5, wobei das zweite Substrat mit dem ersten Dichtungselement, dem zweiten Dichtungselement und dem dritten Dichtungselement abdichtet, um ein Vakuum im inneren Hohlraum zu bilden.

7. Abdichtbare Vorrichtung nach Anspruch 1, die ferner eine mikroelektromechanische Baugruppe umfasst, wobei die mikroelektromechanische Baugruppe Folgendes umfasst:
das erste Substrat;
das erste Dichtungselement (204), wobei das erste Dichtungselement (204) auf dem ersten Substrat so strukturiert ist, dass es den inneren Hohlraum (202), in dem die mikroelektromechanische Vorrichtung (206) in einem Abstand zum ersten Dichtungselement (204) angeordnet ist, vollständig umgibt;
das zweite Dichtungselement (214), wobei das zweite Dichtungselement (214) auf dem ersten Substrat (208) so strukturiert ist, dass es das erste Dichtungselement (204) in einem Abstand zum ersten Dichtungselement (204) vollständig umgibt;
eine erste Dichtungsregion (230), die in dem Hohlraum (202) definiert ist;
eine zweite Dichtungsregion (240), die zwischen dem ersten Dichtungselement (204) und dem zweiten Dichtungselement (214) definiert ist;
ein erstes Gettermaterial (210), das in der ersten Dichtungsregion (230) positioniert ist; und
ein zweites Gettermaterial (220), das in der zweiten Dichtungsregion (240) positioniert ist.

8. Abdichtbare Vorrichtung nach Anspruch 7, wobei das erste und zweite Gettermaterial ein jeweils in der ersten und zweiten Dichtungsregion abgeschiedenes Material umfassen, und wobei das erste und zweite Gettermaterial zum Entfernen von Gasen aus der ersten und zweiten Dichtungsregion bei Evakuierung und Erhitzung der ersten und zweiten Dichtungsregion konfiguriert sind.

9. Abdichtbare Vorrichtung nach Anspruch 8, wobei die Evakuierung der zweiten Dichtungsregion größer ist als die Evakuierung des ersten Dichtungsregion, um in der ersten Dichtungsregion einen höheren Druck als in der zweiten Dichtungsregion zu erzeugen.

10. Abdichtbare Vorrichtung nach Anspruch 9, wobei der Druck in der ersten und zweiten Dichtungsregion weniger als eine Atmosphäre und vorzugsweise weniger als 0,5 Atmosphären beträgt.

11. Abdichtbare Vorrichtung nach Anspruch 7, wobei das erste und zweite Dichtungselement auf dem ersten Substrat durch Abscheiden eines Dichtungsmaterials auf das erste Substrat und selektives Entfernen des abgeschiedenen Dichtungsmaterials strukturiert sind, wobei das erste und zweite Dichtungselement im Wesentlichen koplanar zueinander auf dem ersten Substrat verbleiben.

12. Abdichtbare Vorrichtung nach Anspruch 7, wobei die mikroelektromechanische Baugruppe ferner ein zweites Substrat zum ersten Substrat parallel beabstandet umfasst, zwischen denen das erste und das zweite Dichtungselement hermetisch abgedichtet sind.

13. Abdichtbare Vorrichtung nach Anspruch 12, wobei das erste Substrat und das zweite Substrat Halbleitersubstrate umfassen.

14. Abdichtbare Vorrichtung nach Anspruch 12, wobei das erste Gettermaterial auf einer dem ersten Substrat zugewandten Fläche des zweiten Substrats abgeschieden ist.

15. Abdichtbare Vorrichtung nach Anspruch 13, wobei das zweite Gettermaterial auf einer dem zweiten Substrat zugewandten Fläche des ersten Substrats abgeschieden ist.

## Revendications

1. Dispositif scellable (200) comprenant :
un premier substrat (208) ;
un premier élément d'étanchéité (204) positionné sur le premier substrat (208), le premier élément d'étanchéité (204) délimitant une cavité interne (202) ;
un dispositif micro-électromécanique (206) positionné à l'intérieur de la cavité interne (202) ;
un deuxième élément d'étanchéité (214) positionné à l'extérieur du premier élément d'étanchéité (204) ;
une région d'étanchéité (240) délimitée entre le premier élément d'étanchéité (204) et le deuxième élément d'étanchéité (214) ;
et **caractérisé en ce que**
un matériau sorbeur (220) est positionné à l'intérieur de la région d'étanchéité (240), le matériau sorbeur étant conçu pour supprimer des gaz de la région d'étanchéité.

2. Dispositif scellable selon la revendication 1, dans lequel le matériau sorbeur est un deuxième matériau sorbeur, comprenant en outre un deuxième substrat, dans lequel un premier matériau sorbeur est positionné sur le deuxième substrat, le premier matériau sorbeur étant conçu pour supprimer des gaz de la cavité interne.

3. Dispositif scellable selon la revendication 2, dans lequel le deuxième substrat se scelle avec le premier élément d'étanchéité et le deuxième élément d'étanchéité pour former un vide dans la cavité interne.

4. Dispositif scellable selon la revendication 1, dans lequel le matériau sorbeur est un deuxième matériau sorbeur et dans lequel la région d'étanchéité est une deuxième région d'étanchéité, comprenant en outre un troisième élément d'étanchéité positionné à l'extérieur du deuxième élément d'étanchéité ; une troisième région d'étanchéité étant délimitée entre le troisième élément d'étanchéité et le deuxième élément d'étanchéité ; et un troisième matériau sorbeur étant positionné à l'intérieur de la troisième région d'étanchéité, le deuxième matériau sorbeur étant conçu pour supprimer des gaz de la région d'étanchéité.

5. Dispositif scellable selon la revendication 4, comprenant en outre un deuxième substrat, dans lequel un premier matériau sorbeur est positionné sur le deuxième substrat, le premier matériau sorbeur étant conçu pour supprimer des gaz de la cavité interne.

6. Dispositif scellable selon la revendication 5, dans lequel le deuxième substrat se scelle avec le premier élément d'étanchéité, le deuxième élément d'étanchéité et le troisième élément d'étanchéité pour former un vide dans la cavité interne.

7. Dispositif scellable selon la revendication 1, comprenant en outre un ensemble micro-électromécanique, dans lequel l'ensemble micro-électromécanique comprend :
le premier substrat ;
le premier élément d'étanchéité (204), le premier élément d'étanchéité (204) étant façonné sur le premier substrat en entourant entièrement la cavité interne (202) dans laquelle est agencé le dispositif micro-électromécanique (206) à distance du premier élément d'étanchéité (204) ;
le deuxième élément d'étanchéité (214), le deuxième élément d'étanchéité (214) étant façonné sur le premier substrat (208) en entourant entièrement le premier élément d'étanchéité (204) à distance du premier élément d'étanchéité (204) ;
une première région d'étanchéité (230) délimitée dans la cavité (202) ;
une deuxième région d'étanchéité (240) délimitée entre le premier élément d'étanchéité (204) et le deuxième élément d'étanchéité (214) ;
un premier matériau sorbeur (210) positionné dans la première région d'étanchéité (230) ; et
un deuxième matériau sorbeur (220) positionné dans la deuxième région d'étanchéité (240).

8. Dispositif scellable selon la revendication 7, dans lequel les premier et deuxième matériaux sorbeur comprennent un matériau déposé dans les première et deuxième régions d'étanchéité, respectivement, et, lors d'une évacuation et d'un chauffage des première et deuxième régions d'étanchéité, les premier et deuxième matériaux sorbeur sont conçus pour supprimer des gaz des première et deuxième régions d'étanchéité.

9. Dispositif scellable selon la revendication 8, dans lequel l'évacuation de la deuxième région d'étanchéité est supérieure à l'évacuation de la première région d'étanchéité afin de créer une pression plus grande dans la première région d'étanchéité que dans la deuxième région d'étanchéité.

10. Dispositif scellable selon la revendication 9, dans lequel la pression dans les première et deuxième régions d'étanchéité est inférieure à une atmosphère, et de préférence inférieure à 0,5 atmosphère.

11. Dispositif scellable selon la revendication 7, dans lequel les premier et deuxième éléments d'étanchéité sont façonnés sur le premier substrat par dépôt d'un matériau d'étanchéité sur le premier substrat et élimination sélective du matériau d'étanchéité déposé laissant les premier et deuxième éléments d'étanchéité sensiblement coplanaires l'un par rapport à l'autre sur le premier substrat.

12. Dispositif scellable selon la revendication 7, dans lequel l'ensemble micro-électromécanique comprend en outre un deuxième substrat espacé parallèle au premier substrat et ayant les premier et deuxième éléments d'étanchéité hermétiquement scellés entre eux.

13. Dispositif scellable selon la revendication 12, dans lequel le premier substrat et le deuxième substrat comprennent des substrats semi-conducteurs.

14. Dispositif scellable selon la revendication 12, dans lequel le premier matériau sorbeur est déposé sur une surface du deuxième substrat qui fait face au premier substrat.

15. Dispositif scellable selon la revendication 13, dans lequel le deuxième matériau sorbeur est déposé sur une surface du premier substrat qui fait face au deuxième substrat.
